# EUROPÄISCHE PATENTSCHRIFT

(11) **EP 3 225 085 B1**
(45) Veröffentlichungstag und Bekanntmachung des Hinweises auf die Patenterteilung: **08.09.2021**
(21) Anmeldenummer: 15771082.3
(22) Anmeldetag: 25.09.2015
(51) Int. Cl.: H05K 1/18, H05K 5/00, H05K 3/30, H05K 3/32

(54) **ELEKTRONIKMODUL, INSBESONDERE FÜR KFZ-GETRIEBESTEUERGERÄT, MIT PRESSKONTAKT-SANDWICH-MODUL-TECHNIK**
ELECTRONICS MODULE, IN PARTICULAR FOR A MOTOR VEHICLE TRANSMISSION CONTROL UNIT, COMPRISING PRESS CONTACT SANDWICH MODULE TECHNOLOGY
MODULE ÉLECTRONIQUE, NOTAMMENT POUR UNITÉ DE COMMANDE DE BOÎTE DE VITESSES DE VÉHICULE, COMPRENANT UNE TECHNIQUE DE MODULE EN SANDWICH À CONTACTS À PRESSION

(30) Priorität: 25.11.2014 DE 102014224033
(43) Veröffentlichungstag der Anmeldung: 04.10.2017
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2015/072067
(87) Internationale Veröffentlichungsnummer: WO 2016/082974

(56) Entgegenhaltungen:
- DE-A1-102005 062 601
- DE-A1-102011 085 170
- DE-A1-102011 085 172
- US-A1- 2008 106 898
- None

## Beschreibung

### Gebiet der Erfindung

Die Erfindung betrifft ein Elektronikmodul, wie es insbesondere für Kfz-Getriebesteuergeräte eingesetzt werden kann.

### Hintergrund der Erfindung

Elektronikmodule werden unter anderem zum Erfassen, Verarbeiten und/oder Ausgeben von Signalen und Daten eingesetzt. Beispielsweise werden Elektronikmodule in Kraftfahrzeugen in Form von Steuergeräten eingesetzt, um z.B. Signale von Sensoren aufzunehmen und dann darauf basierend Komponenten des Fahrzeugs wie beispielsweise einen Motor oder ein automatisiertes Getriebe zu steuern.

Insbesondere beim Einsatz als Getriebesteuergerät werden an ein Elektronikmodul hohe Anforderungen gestellt. Neben den typischerweise bei Kraftfahrzeuganwendungen auftretenden mechanischen Belastungen durch Vibrationen und temperaturbedingte Ausdehnungen kommen Komponenten eines beispielsweise innerhalb eines Fahrzeuggetriebes verbauten Elektronikmoduls in Kontakt mit chemisch aggressiven Medien wie z.B. Getriebeöl. Es müssen daher Vorkehrungen getroffen werden, um eine Schädigung dieser Komponenten aufgrund eines solchen Kontakts zu vermeiden.

Herkömmlich weisen Elektronikmodule mehrere Elektronikbauelemente wie z.B. elektrische Widerstände, Spulen, Kondensatoren, integrierte Schaltungen (ICs), verschiedene Arten von Sensoren, Aktuatoren und Steckern oder ähnliches auf, die auf einem Substrat mechanisch gehalten sind und über dieses untereinander elektrisch verschaltet sind. Das Substrat kann beispielsweise eine Leiterplatte sein, teilweise auch als Platine oder PCB (Printed Circuit Board) bezeichnet. Auf oder in der Leiterplatte können Leiterbahnen zum Verschalten der Bauelemente vorgesehen sein. Alternativ können die Bauelemente an Stanzgittern angeordnet und mit deren Hilfe verschaltet sein.

DE 10 2010 042019 A1 beschreibt ein Beispiel eines als Getriebesteuergerät dienenden Elektronikmoduls.

Die Elektronikbauelemente werden bisher mit den Leiterbahnen der Leiterplatte meist verlötet oder verschweißt. Hierzu notwendige Werkzeuge und Arbeitsgänge können aufwändig sein. Außerdem wurde beispielsweise bei Verlötungen festgestellt, dass besondere Vorkehrungen getroffen werden müssen, um eine dauerhafte Zuverlässigkeit der hierdurch geschaffenen elektrischen Verbindungen zu gewährleisten, insbesondere seitdem neueren Standards folgend bleifreie Lote eingesetzt werden müssen, die sehr hart und somit unelastisch sind.

Weitere Elektronikmodule sind aus der DE 10 2011 085 170 A1, der US 2008/106898 A1, der DE 10 2005 062 601 A1 und der DE 10 2011 085 172 A1 bekannt.

### Offenbarung der Erfindung

Ausführungsformen der vorliegenden Erfindung können in vorteilhafter Weise unter anderem ermöglichen, Elektronikmodule einfach fertigen zu können und sie dabei derart auszubilden, dass eine langfristig zuverlässige Funktion auch unter schwierigen Umgebungsbedingungen, beispielsweise beim Einsatz als Getriebesteuergerät, gewährleistet werden kann.

Gemäß einem ersten Aspekt der Erfindung wird ein Elektronikmodul vorgeschlagen, wie es insbesondere für ein Getriebesteuergerät für ein Kraftfahrzeug eingesetzt werden kann. Das Elektronikmodul weist eine Trägerplatte, eine Leiterplatte mit daran angeordneten Leiterbahnen sowie wenigstens ein Elektronikbauelement auf. Das Elektronikbauelement ist über Presskontakte mit Leiterbahnen der Leiterplatte elektrisch verbunden. Das Elektronikmodul zeichnet sich dadurch aus, dass zumindest Teilbereiche des Elektronikbauelements einen Sockel aufweisen, wobei ein Abstand zwischen der Trägerplatte und der Leiterplatte einer Dicke des Sockels entspricht und der Sockel zwischen der Trägerplatte und der Leiterplatte derart eingeklemmt ist, dass das Elektronikbauelement in einer Richtung quer zur Trägerplatte durch Formschluss festgelegt ist. Bereiche von Leiterbahnen der Leiterplatte angrenzend an einen der Presskontakte sind von einer ausgehärteten flüssigverarbeitbaren Schicht bedeckt, wobei die Leiterplatte eine Öffnung aufweist und das Elektronikbauelement durch die Öffnung hindurch ragt.

Ausgehend von der oben angegebenen Erkenntnis, dass ein Verlöten oder Verschweißen von elektronischen Bauelementen mit Leiterbahnen technologisch aufwändig ist und Lötverbindungen eine nicht vernachlässigbare Ausfallwahrscheinlichkeit aufweisen können, wurde eine Technologie entwickelt, um Elektronikmodule ohne solche Löt- bzw. Schweißschritte und dadurch obligatorisch werdende Prüfvorgänge fertigen zu können.

Die Elektronikbauelemente werden dabei zumindest bereichsweise zwischen der Trägerplatte und der Leiterplatte aufgenommen. Die Trägerplatte kann hierbei hauptsächlich als mechanische Stabilisierung des Elektronikmoduls, als Schutz für die Elektronikbauelemente gegen von außen kommende mechanische wie auch chemische Angriffe sowie gegebenenfalls zur Entwärmung der Elektronikbauelemente dienen. Die Leiterplatte kann zusätzlich zu diesen Funktionen auch noch zur elektrischen Verschaltung der Bauelemente untereinander bzw. mit äußeren elektrischen Schaltkreisen dienen. Die Elektronikbauelemente sind derart zwischen der Träger- und der Leiterplatte aufgenommen, d.h. beispielsweise eingeklemmt, dass sie sich nicht mehr quer zur Trägerplatte bzw. Leiterplatte bewegen können, d.h. durch Formschluss festgelegt sind.

Die Elektronikbauelemente werden hierbei mithilfe von Presskontakten mit Leiterbahnen der Leiterplatte elektrisch verbunden. Presskontakte werden teilweise auch als Einpresskontakte oder Kaltkontakte bezeichnet und werden mittels einer sogenannten Einpresstechnik verarbeitet. Als Einpresstechnik wird eine spezielle Verbindungstechnik bezeichnet, um lötfrei elektrische Verbindungen mit Leiterplatten herzustellen. Hierzu muss ein Presskontakt oder Einpressstift in eine zumindest bereichsweise metallisierte Ausnehmung, beispielsweise in Form eines durchgehenden Lochs, einer Leiterplatte gepresst werden. Wesentlich ist hierbei, dass eine Diagonale des Stiftquerschnitts größer ist als ein Durchmesser der Ausnehmung in der Leiterplatte. Eine beim Einpressen entstehende Überpressung kann entweder durch eine Verformung in der Ausnehmung oder eine Verformung von Bereichen des Presskontakts aufgenommen werden. Durch das Einpressen bzw. Einschneiden von Kanten des Presskontakts in die in Bereichen der Ausnehmung vorhandene Metallisierung kann eine gasdichte elektrische Verbindung entstehen, die sich bei richtiger Ausführung durch eine hohe Zuverlässigkeit und Langlebigkeit auszeichnet.

Der Einsatz von Presskontakten und der Einpresstechnik zu Ihrer Verarbeitung anstatt herkömmlicher Löt- oder Schweißtechniken erlaubt, Kosten eines Elektronikmoduls zu reduzieren. Beispielsweise lassen sich Erprobungs- und Entwicklungskosten senken. Die Einfachheit der zur Fertigung einsetzbaren Technologien kann ferner erlauben, Änderungen oder Varianten im Design eines Elektronikmoduls sehr leicht und schnell umzusetzen, ohne großen Aufwand für Werkzeuge und Anlagen. Eine Fertigung von Elektronikmodulen wird dadurch vereinfacht, verbilligt und technologisch weltweit ausführbar.

Außerdem kann das Design des Elektronikmoduls robuster gemacht werden. Insbesondere entfällt ein Risiko von Lötstellenzerrüttungen. Außerdem können thermischen Verspannungen reduziert werden. Thermische Ausdehnungskoeffizienten (CTE) von Komponenten des Elektronikmoduls können im Bereich der CTEs z.B. großer Getriebebauteile wie Wellen und Zahnräder, die mit einem Getriebesteuergerät sensiert werden sollen, gewählt werden. Gleichzeitig kann eine geringere Differenz zum CTE beispielsweise einer Aluminium-Steuerplatte in einem Getriebe erreicht werden im Vergleich zu Modulen mit Kunststoffträgerplatten. Insgesamt lässt sich eine Erhöhung der Belastbarkeit und Temperaturfestigkeit erreichen, da zwischen Komponenten des Elektronikmoduls geringere Unterschiede bezüglich ihrer thermischen Ausdehnungskoeffizienten eingestellt werden können. Eine Verbindung der Presskontakte zu der Leiterplatte kann nahezu ohne mechanische Verspannungen erfolgen, da kein Erwärmen während der Fertigung auf Temperaturen oberhalb späterer Betriebstemperaturen, typischerweise etwa 150°C, erfolgt, wohingegen herkömmliches Löten beispielsweise mit Fertigungstemperaturen von üblicherweise mehr als 240°C einhergeht. Ferner lassen sich ausgeprägte thermische Spannungen innerhalb des Moduls vermeiden, da alle Baugruppen und -elemente lediglich lokal im Kontakt zueinander stehen. Presskontakte in der Leiterplatte werden nicht durch eine Trägerplatte relativ zur Leiterplatte verschoben (CTE-Unterschiede) und damit sind diese frei von Querkräften, im Gegensatz zu gelöteten Pins, die bei Temperaturwechselbelastungen eine Gefahr von Lötstellenzerrüttungen bergen.

Aufgrund der Anordnung der Elektronikbauelemente im Wesentlichen zwischen der Leiterplatte und der Trägerplatte und ihrer mechanischen Festlegung durch diese Platten, können im Vergleich zu manchen herkömmlichen Elektronikmodulen Federn zur Befestigung von Elektronikbauelementen und/oder Spannschutzdeckel an Ober- oder Unterseite des Elektronikmoduls entfallen.

Es wurde beobachtet, dass es an Presskontaktverbindungen nach dem Einpressen in die Leiterplatte lokal zu Degradationserscheinungen kommen kann. Eine mögliche Erklärung hierfür ist, dass es beim Einpressen der Presskontakte zu Beschädigungen der mit den Leiterbahnen in Kontakt stehenden Metallschicht kommen kann. Beispielsweise könnte es beim Einpressen dazu kommen, dass eine Schutzschicht z.B. aus Zinn, welche eine darunter liegende, gut elektrisch leitfähige Kupferschicht schützen soll, zerkratzt wird, sodass die Kupferschicht entlang eines Kratzers nach außen ungeschützt freiliegt. In diesen freiliegenden Bereichen könnte es dann beispielsweise bei einem Kontakt mit chemisch aggressiven Medien zu einer Schädigung, beispielsweise durch Korrosion, kommen.

Es wird daher vorgeschlagen, Bereiche von Leiterbahnen der Leiterplatte angrenzend an einen der Presskontakte mit einer aushärtbaren flüssigen Schicht zu bedecken und diese anschließend auszuhärten. Insbesondere können die Presskontakte des Elektronikbauteils in Ausnehmungen in der Leiterplatte eingreifen und die ausgehärtete flüssigverarbeitbare Schicht zumindest Teilbereiche der Ausnehmungen bedecken. Die Ausnehmungen können hierbei beispielsweise als durchgängige Öffnungen, d.h. Durchgangslöcher, ausgebildet sein, in die Presskontakte beim Montieren des Elektronikmodul eingepresst werden. An Innenwänden der Ausnehmungen können zumindest in Teilbereichen eine oder mehrere Metallschichten angeordnet sein, die in elektrischem Kontakt mit den Leiterbahnen der Leiterplatte stehen.

Die ausgehärtete flüssigverarbeitbare Schicht kann beispielsweise aus einem Klebstoff oder einem Lack bestehen. Beispielsweise kann diese Schicht mit einem epoxidharzbasierten Klebstoff, wie er z.B. auch zum Vergießen von Chips verwendet wird und als "glob-top" bezeichnet wird, ausgebildet werden. Alternativ kann die Schicht mittels eines aushärtenden Lacks gebildet werden.

Es kann vorteilhaft sein, wenn das Elektronikbauelement nicht mit der Trägerplatte verklebt ist. Das Elektronikbauelement kann sich dann relativ zu der Trägerplatte bewegen, d.h. ist in Bezug auf diese schwimmend gehalten, sodass z.B. übermäßige mechanische Spannungen zwischen dem Elektronikbauelement und der Trägerplatte beispielsweise aufgrund unterschiedlicher Wärmeausdehnungskoeffizienten vermieden werden können.

Gemäß der Erfindung weist die Leiterplatte eine Öffnung auf und das Elektronikbauelement ragt durch diese Öffnung hindurch. Mit anderen Worten ist das Elektronikbauelement nicht vollständig zwischen der Leiterplatte und der Trägerplatte aufgenommen, sondern die Leiterplatte weist eine oder mehrere Öffnungen auf, durch die Teilbereiche zugeordneter Elektronikbauelement hindurch nach außen ragen. Beispielsweise kann ein Sensor mit einem Sockel zwischen der Leiterplatte und der Trägerplatte eingeklemmt sein, ein mit einer Detektionsfläche versehener Bereich des Sensors jedoch ragt durch die Öffnung nach außen über die Leiterplatte über und steht somit von dem Elektronikmodul nach außen hin ab, beispielsweise hin zu einem zu sensierenden Bauteil wie eine Getriebezahnrad. Die Öffnungen sind deutlich größer als die Durchgangslöcher, in die die Presskontakte eingepresst werden.

Die Öffnung kann hierbei nicht-rotationssymmetrisch sein und das Elektronikbauelement formschlüssig in die Öffnung eingreifen. Eine räumliche Anordnung des Elektronikbauteils ist in diesem Fall nicht nur aufgrund der Position der Öffnung, durch die es hindurchragt, hinsichtlich seiner eigenen Position festgelegt, sondern ist auch hinsichtlich seiner Orientierung festgelegt, damit es passend formschlüssig in die Öffnung eingreifen kann.

Gemäß einer Ausführungsform ist das Elektronikbauelement mittels eines in die Trägerplatte und/oder die Leiterplatte eingreifenden Fixierelements in einer Richtung parallel zur Trägerplatte festgelegt. Mit anderen Worten ist das Elektronikbauelement nicht nur zwischen Träger- und Leiterplatte eingeklemmt und somit gegenüber einer Verlagerung quer zu diesen Platten festgelegt, sondern ist ergänzend auch mittels des eingreifenden Fixierelements parallel zu den Platten festgelegt. Das Fixierelement kann beispielsweise ein Stift, Bolzen, Schraube, Niet oder ähnliches sein.

Gemäß einer Ausführungsform ist zwischen Bereichen der Leiterplatte angrenzend an einen der Presskontakte und einem benachbarten Bereich des Elektronikbauelements ein mit Material der ausgehärteten flüssigverarbeitbaren Schicht gefüllter Spalt angeordnet. Der Spalt kann sich, wenn der Klebstoff oder Lack auf die Bereiche angrenzend an die Presskontakte aufgetragen wird, mit dem Klebstoff bzw. Lack füllen und dann nach dem Aushärten das Elektronikbauelement und die Leiterplatte miteinander verkleben.

Es kann vorteilhaft sein, die Trägerplatte und/oder die Leiterplatte mit faserverstärktem Epoxidharz auszubilden. Mit anderen Worten können beide Platten aus einem gleichen Material als Grundstoff ausgebildet sein, wobei die Leiterplatte im Gegensatz zur Trägerplatte ergänzend mit Leiterbahnen versehen ist. Die beiden Platten können somit ein gleiches oder zumindest ähnliches Wärmeausdehnungsverhalten aufweisen.

Alternativ kann die Trägerplatte mit einem Kunststoff, insbesondere Polyamid, und/oder mit Metall ausgebildet sein. Kunststoffplatten können unter anderem sehr kostengünstig hergestellt werden. Metallplatten können ergänzend für eine gute Wärmeableitung sorgen. In einer speziellen Ausgestaltung kann die Trägerplatte Teilbereiche mit im Vergleich zu umliegenden Bereichen erhöhter Wärmeleitfähigkeit aufweisen. Beispielsweise kann in einer kunststoffbasierten Trägerplatte ein metallischer Bereich eingelagert sein, beispielsweise in Form eines Inlays oder thermischer Vias, um Wärme lokal besonders gut ableiten zu können.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
Fign. 1 und 2 zeigen ein Schnittansicht und eine Draufsicht auf ein erfindungsgemäßes Elektronikmodul.
Fign. 3 bis 5 veranschaulichen einen Montagevorgang für ein erfindungsgemäßes Elektronikmodul.
Fign. 6 bis 8 zeigen Schnittansichten bzw. eine Draufsicht weiterer Ausführungsformen eines erfindungsgemäßen Elektronikmoduls.
Fig. 9 zeigt eine spezielle Ausgestaltung eines Elektronikbauelements in einer Ausführungsform eines erfindungsgemäßen Elektronikmoduls.
Fig. 10 veranschaulicht ein Getriebesteuergerät unter Einsatz eines erfindungsgemäßen Elektronikmoduls.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

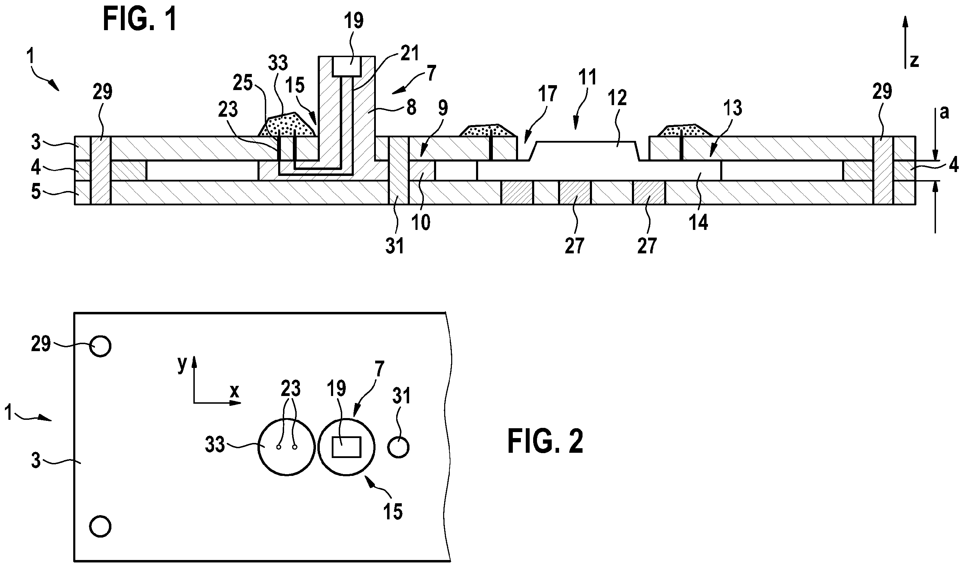

Fig. 1 und 2 zeigen ein Elektronikmodul 1 mit einer obenliegenden Leiterplatte 3 und einer untenliegenden Trägerplatte 5. Die Trägerplatte 5 besteht ähnlich wie die Leiterplatte 3 aus einem glasfaserverstärkten Epoxidharzmaterial, welches beispielsweise in Form übereinander geschichteter sogenannter Prepregs, d.h. mehrerer etwa 0,2mm dünner zusammenlaminierter Schichten, vorgesehen werden kann. Die Trägerplatte 5 kann beispielsweise eine Dicke von 0,6 bis 1,6mm aufweisen. Die Leiterplatte 3 hat typischerweise eine Dicke von 1,6mm und weist an ihrer Oberfläche oder in ihrem Inneren, z.B. zwischen einzelnen Prepreg-Schichten, Leiterbahnen (nicht dargestellt) auf. Die Trägerplatte 5 weist im Allgemeinen keine Leiterbahnen auf, kann aber zur besseren Entwärmung metallische Inlays oder Vias 27 aufweisen.

Zwischen die parallel zueinander angeordnete Leiter- und Trägerplatte 3, 5 sind Teilbereiche 9, 13 von Elektronikbauelementen 7, 11 in Form eines Sensors 8 bzw. einer Getriebesteuerelektronik 12 (TCU - transmission control unit) sowie Abstandhalter 4 zwischengelagert. Die Elektronikbauelemente 7, 11 weisen in den Teilbereichen 9, 13 jeweils Sockel 10, 14 auf, die zwischen der Trägerplatte 5 und der Leiterplatte 3 eingeklemmt sind. Ein Abstand a zwischen der Trägerplatte 5 und der Leiterplatte 3 entspricht dabei einer Dicke der Sockel 10, 14, beispielsweise zwischen 2,5 und 5mm, sodass die Elektronikbauelemente 7, 11 über ihre formschlüssig zwischen die Trägerplatte 5 und die Leiterplatte 3 eingreifenden Sockel 10, 14 in einer Richtung z quer zu der Trägerplatte 5 festgelegt ist. Die Leiterplatte 3 und die Trägerplatte 5 sind mittels Befestigungselementen 29 wie Nieten, Schrauben, eingeklebter Pins oder Verstemmung aneinander gehalten und klemmen dabei die Sockel 10, 14 der Elektronikelement 7, 11 sandwich-artig ein.

In der Leiterplatte 3 sind jeweils Öffnungen 15, 17 vorgesehen, durch die andere Teilbereiche der Elektronikbauelemente 7, 11 nach außen hindurchragen. Beispielsweise ragt ein ein Sensorelement 19 aufweisender Teilbereich des Sensors 8 durch die Öffnung 15 nach oben, d.h. beispielsweise hin zu einem zu sensierenden Zahnrad eines Kfz-Getriebes (nicht dargestellt). Die Öffnungen 15, 17 können Querschnittsflächen von mehr als 1mm² oder auch mehr als 5mm² aufweisen.

Im dargestellten Beispiel aus Fig. 1 und 2 sind der obere Bereich des Sensors 8 sowie die Öffnung 15 rund und weisen im Wesentlichen gleiche Querschnitte auf, sodass der obere Bereich des Sensors 8 formschlüssig in die Öffnung 15 eingreift. Auf diese Weise ist der Sensor 8 bezüglich seiner Position in einer xy-Ebene, d.h. parallel zur Trägerplatte 3, festgelegt.

Das Sensorelement 19 des Sensors 8 steht über Leitbleche 21 mit Presskontakten 23 in elektrischer Verbindung. Die Presskontakte 23 ragen aus dem Sockel 10 nach oben in Richtung hin zu der Leiterplatte 3. In der Leiterplatte 3 sind an hierzu korrespondierenden Positionen kleine Durchgangslöcher 25 vorgesehen. Ein Innendurchmesser die Durchgangslöcher 25 ist geringfügig kleiner als maximale Querabmessungen der Presskontakte 23. Typischerweise haben die Durchgangslöcher 25 Querschnittsflächen von weniger als 5mm² oder auch weniger als 1mm².

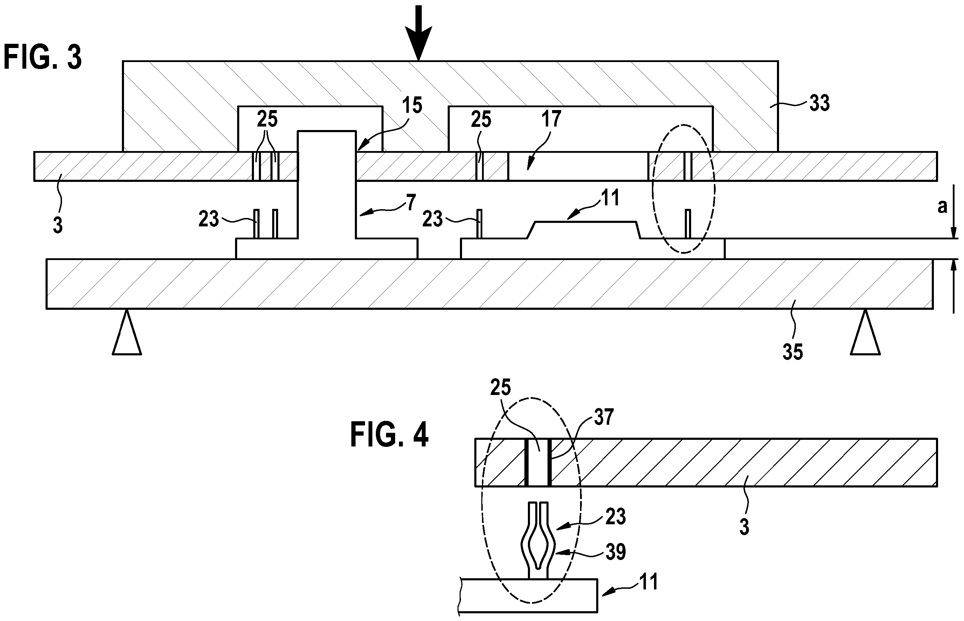

An einer Innenoberfläche der Durchgangslöcher 25 ist eine Metallschicht 37 (siehe Fig. 4) vorgesehen, die in elektrischem Kontakt mit Leiterbahnen der Leiterplatte 3 steht. Die Metallschicht 37 kann beispielsweise aus einer Kupferschicht sowie einer diese Kupferschicht nach außen abdeckenden Schutzschicht, beispielsweise aus Zinn oder Gold, bestehen.

Bei einer Montage des Elektronikmoduls 1 werden die Presskontakte 23 in die Löcher 25 derart eingepresst, dass sich eine mechanisch stabile und elektrisch zuverlässige Verbindung zwischen den Presskontakten 23 und der in den Durchgangslöchern 25 der Leiterplatte 3 vorgesehenen Metallschicht 37 ergibt. Wie in den Fign. 3 und 4 veranschaulicht, kann die Leiterplatte 3 mit ihren an geeigneten Stellen ausgebildeten Durchgangslöchern 25 und Öffnungen 15, 17 mittels eines Stempels 33 auf bereitgestellte und von unten durch eine Platte 35 einer Einpressvorrichtung gehaltene Elektronikbauelemente 7, 11 aufgepresst werden. Die Presskontakte 23 werden dabei in die Löcher 25 eingeschoben. Da die stiftartigen Presskontakte 23 einen verbreiterten Bereich 39 haben, in dem sie breiter sind als die Löcher 25, werden die Presskontakte 23 und/oder die an der Innenoberfläche des Löcher 25 vorgesehene Metallschicht 37 beim Einpressen lokal deformiert. Es kommt zu einer kalten Verpressung, die einen stabilen und zuverlässigen elektrischen Kontakt zwischen Presskontakt 23 und Metallschicht 37 bewirkt.

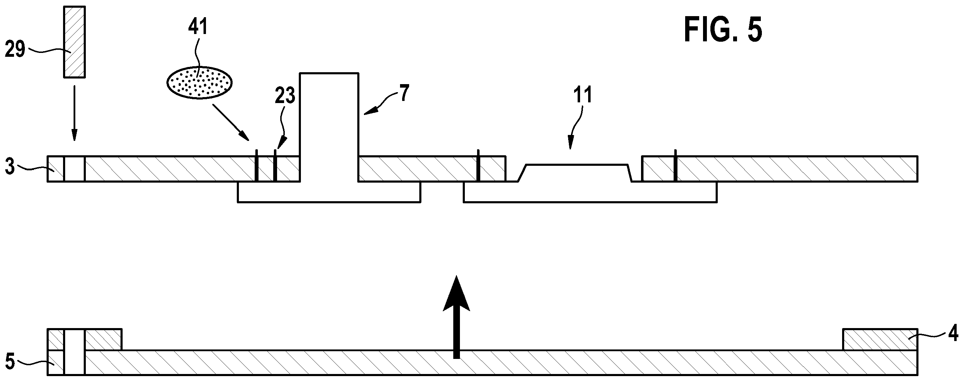

Nachdem die Elektronikbauelemente 7, 11 an der Leiterplatte 3 angebracht wurden, wird, wie in Fig. 5 dargestellt, die Trägerplatte 5 an der gegenüberliegenden Seite der Elektronikbauelemente 7, 11 angeordnet und mittels Befestigungselementen 29 befestigt.

Außerdem werden freiliegende Enden der Presskontakte 23 sowie angrenzende Bereiche um die Durchgangslöcher 25 mit einer flüssigverarbeitbaren Schicht 33 (siehe Fign. 1, 2) aus epoxidharz-basiertem Klebstoff 41 oder Lack bedeckt. Anschließend kann der epoxidbasierte Klebstoff 41 oder Lack z.B. thermisch oder mittels UV-Beleuchtung ausgehärtet werden. Dabei kann er zwischenzeitlich sehr dünnflüssig werden und in die Durchgangslöcher 25 eindringen und deren Innenoberflächen benetzen. Gegebenenfalls kann er sogar bis zwischen den Sockel 10, 14 des Elektronikbauelements 7, 11 und die Leiterplatte 3 vordringen und diese miteinander verkleben. Nach dem Aushärten bietet die Schicht 33 Schutz z.B. gegen einen elektrischen Kontakt durch Metallspäne. Außerdem sind die von der Schicht 33 bedeckten Flächen gegen einen Angriff durch aggressive Chemikalien wie Getriebeöl geschützt. Insbesondere sind mögliche Kratzspuren im Innern der Durchgangslöcher 25, an denen beim Einpressen der Presskontakte 23 eine ansonsten schützende Zinnschicht beschädigt wurde und eine darunterliegende Kupferschicht freiliegt, gegen einen Kontakt mit solchen Chemikalien geschützt.

Um die Elektronikbauelemente 7, 11 nicht nur hinsichtlich ihrer Position sondern auch hinsichtlich ihrer Orientierung festlegen zu können, können Fixierelemente 31 vorgesehen sein, die ähnlich den Befestigungselementen 29 (siehe Fig. 1) beispielsweise als Niete, Schrauben oder ähnliches ausgebildet sein können. Die Fixierelemente 31 können einerseits in die Leiterplatte 3 in dort vorgesehene Ausnehmungen und andererseits z.B. in Sockel 10, 14 der Elektronikbauelemente 7, 11 eingreifen, um letztere bezüglich einer Ebene der Leiterplatte 3 festzulegen und somit in ihrer Orientierung zu fixieren.

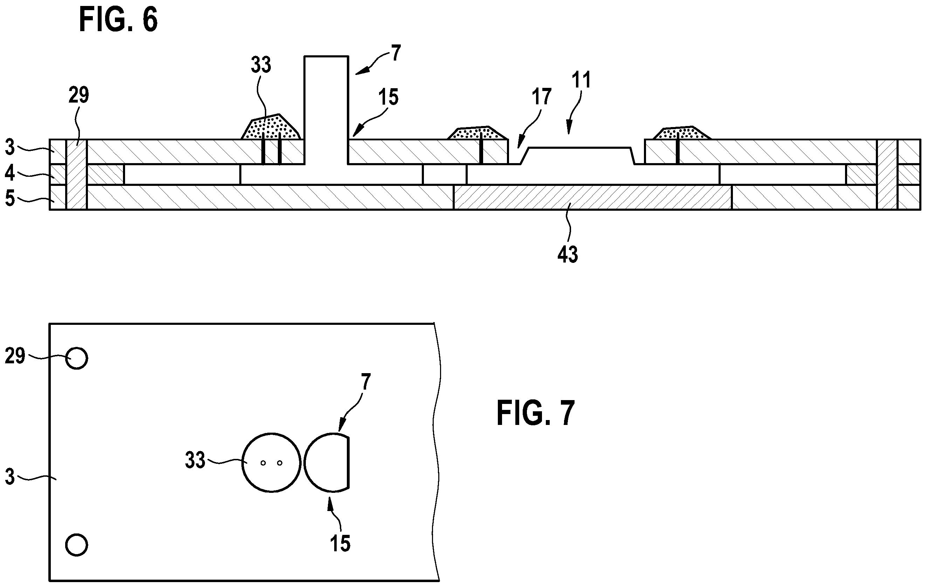

Alternativ können die Öffnungen 15, 17 wie auch die durch diese Öffnungen 15, 17 hindurchragenden Bereiche der Elektronikelemente 7, 11, wie in Fig. 6 und 7 veranschaulicht, jeweils einen nicht-rotationssymmetrischen, beispielsweise einen halbrunden, Querschnitt aufweisen, sodass z.B. ein Elektronikelement 7 nach einem Einpassen in die Öffnung 15 auch hinsichtlich seiner Orientierung festgelegt ist.

Bei der in Fig. 6 dargestellten Ausführungsform weist die Trägerplatte 5 zur lokalen Entwärmung der TCU 11 ein Metall-Inlay 43 auf, welches in eine ansonsten aus Kunststoff wie z.B. Polyamid ausgebildete Platte eingelegt ist.

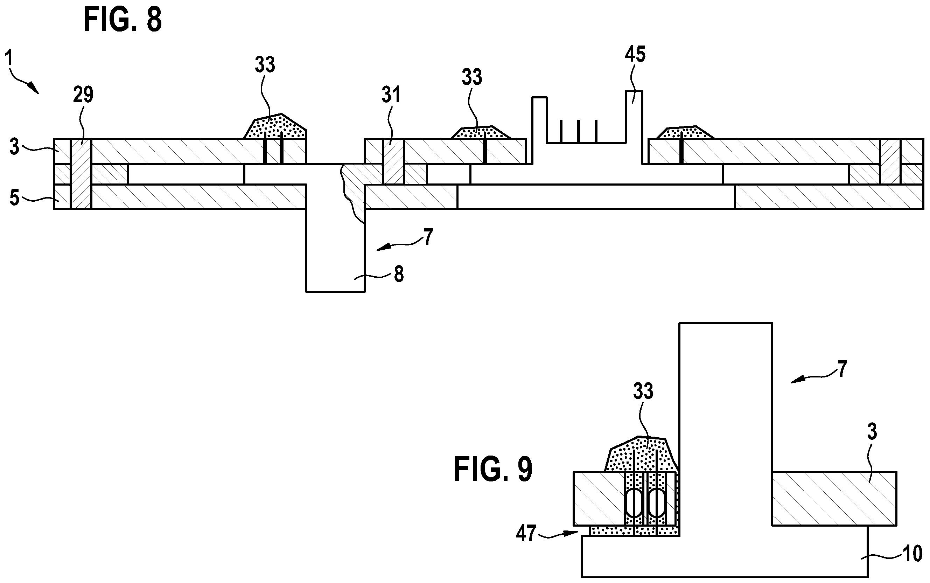

Fig. 8 zeigt eine Ausführungsform eines Elektronikmoduls 1 mit einem nach unten aus der Trägerplatte 5 herausragenden Sensor 8 und einem nach oben aus der Leiterplatte 3 herausragenden Stecker 45.

Fig. 9 zeigt eine Ausgestaltung eines Elektronikbauelements 7 für ein Elektronikmodul, bei dem zwischen Bereichen der Leiterplatte 3 angrenzend an einen der Presskontakte 23 und einem benachbarten Bereich am Sockel 10 des Elektronikbauelements 7 ein mit Klebstoff oder Lack der ausgehärteten flüssigverarbeitbaren Schicht 33 gefüllter Spalt 47 angeordnet ist.

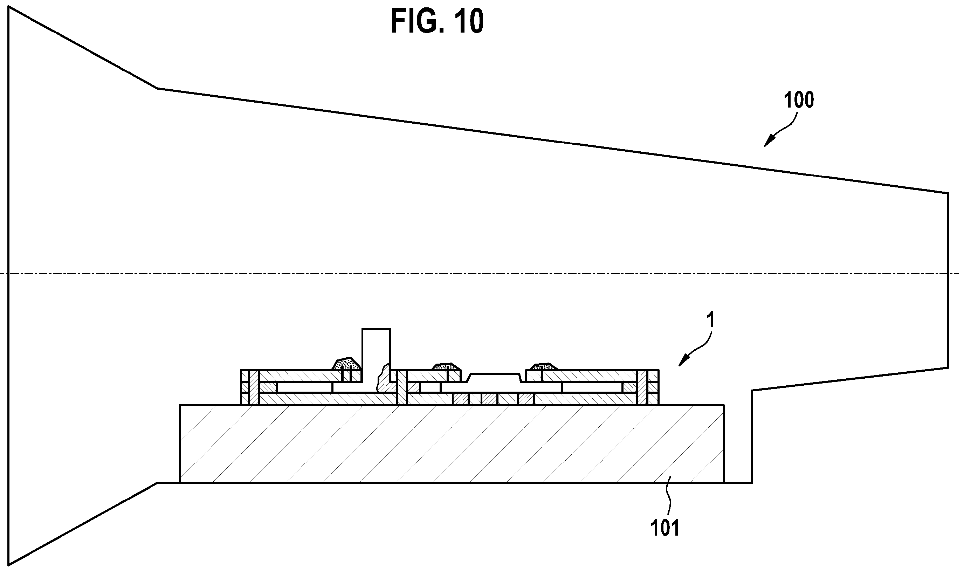

Fig. 10 zeigt Umrisse eines Getriebes 100, in das ein als Getriebesteuergerät dienendes Elektronikmodul 1 auf einer Hydraulikplatte 101 fixiert integriert ist.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Elektronikmodul (1), aufweisend:
eine Trägerplatte (5);
eine Leiterplatte (3) mit daran angeordneten Leiterbahnen;
wenigstens ein Elektronikbauelement (7, 11);
wobei das Elektronikbauelement (7, 11) über Presskontakte (23) mit Leiterbahnen der Leiterplatte (3) elektrisch verbunden ist;
**dadurch gekennzeichnet, dass**
zumindest Teilbereiche (9, 13) des Elektronikbauelements (7, 11) einen Sockel (10, 14) aufweisen, wobei ein Abstand zwischen der Trägerplatte (5) und der Leiterplatte (3) einer Dicke des Sockels (10, 14) entspricht und der Sockel (10, 14) zwischen der Trägerplatte (5) und der Leiterplatte (3) derart einklemmt ist, dass das Elektronikbauelement (7, 11) in einer Richtung quer zur Trägerplatte (5) durch Formschluss festgelegt ist;
und Bereiche von Leiterbahnen der Leiterplatte (5) angrenzend an einen der Presskontakte (23) von einer ausgehärteten flüssigverarbeitbaren Schicht (33) bedeckt sind und wobei die Leiterplatte (3) eine Öffnung (15, 17) aufweist und das Elektronikbauelement (7, 11) durch die Öffnung (15, 17) hindurch ragt.

2. Elektronikmodul nach Anspruch 1, wobei die Presskontakte (23) des Elektronikbauteils (7, 11) in Durchgangslöcher (25) in der Leiterplatte (3) eingreifen und die ausgehärtete flüssigverarbeitbare Schicht (33) zumindest Teilbereiche der Durchgangslöcher (25) bedeckt.

3. Elektronikmodul nach einem der vorangehenden Ansprüche, wobei die ausgehärtete flüssigverarbeitbare Schicht (33) aus einem Klebstoff oder einem Lack besteht.

4. Elektronikmodul nach einem der vorangehenden Ansprüche, wobei das Elektronikbauelement (7, 11) nicht mit der Trägerplatte (5) verklebt ist.

5. Elektronikmodul nach Anspruch 1, wobei die Öffnung (15, 17) nicht rotationssymmetrisch ist und das Elektronikbauelement (7, 11) formschlüssig in die Öffnung (15, 17) eingreift.

6. Elektronikmodul nach einem der vorangehenden Ansprüche, wobei zwischen Bereichen der Leiterplatte (3) angrenzend an einen der Presskontakte (23) und einem benachbarten Bereich des Elektronikbauelements (7, 11) ein mit Material der ausgehärteten flüssigverarbeitbaren Schicht (33) gefüllter Spalt (47) angeordnet ist.

7. Elektronikmodul nach einem der vorangehenden Ansprüche, wobei das Elektronikbauelement (7, 11) mittels eines in die Trägerplatte (5) und/oder die Leiterplatte (3) eingreifenden Fixierelements (31) in einer Richtung parallel zur Trägerplatte (5) festgelegt ist.

8. Elektronikmodul nach einem der vorangehenden Ansprüche, wobei die Trägerplatte (5) und/oder die Leiterplatte (3) mit faserverstärktem Epoxidharz ausgebildet ist.

9. Elektronikmodul nach einem der vorangehenden Ansprüche, wobei die Trägerplatte (5) mit einem Kunststoff, insbesondere Polyamid, und/oder mit Metall ausgebildet ist.

10. Elektronikmodul nach einem der vorangehenden Ansprüche, wobei die Trägerplatte (5) einen metallgefüllten Via (27) und/oder ein Inlay (43) mit im Vergleich zu umliegenden Bereichen erhöhter Wärmeleitfähigkeit aufweist.

11. Steuergerät, insbesondere Getriebesteuergerät für ein Kraftfahrzeug, aufweisend ein Elektronikmodul (1) gemäß einem der vorangehenden Ansprüche.

## Claims

1. Electronics module (1), having:
a carrier plate (5);
a printed circuit board (3) with conductor tracks arranged on it;
at least one electronics component (7, 11);
wherein the electronics component (7, 11) is electrically connected to conductor tracks of the printed circuit board (3) by means of press contacts (23);
**characterized in that**
at least subregions (9, 13) of the electronics component (7, 11) have a base (10, 14), wherein a distance between the carrier plate (5) and the printed circuit board (3) corresponds to a thickness of the base (10, 14) and the base (10, 14) is clamped between the carrier plate (5) and the printed circuit board (3) in such a way that the electronics component (7, 11) is secured in a direction transverse to the carrier plate (5) by way of a positively locking connection;
and regions of conductor tracks of the printed circuit board (5) are covered by a cured liquid-processable layer (33) adjoining one of the press contacts (23), and wherein the printed circuit board (3) has an opening (15, 17) and the electronics component (7, 11) projects through the opening (15, 17).

2. Electronics module according to Claim 1, wherein the press contacts (23) of the electronics component (7, 11) engage into passage holes (25) in the printed circuit board (3) and the cured liquid-processable layer (33) covers at least subregions of the passage holes (25).

3. Electronics module according to either of the preceding claims, wherein the cured liquid-processable layer (33) consists of an adhesive or a lacquer.

4. Electronics module according to one of the preceding claims, wherein the electronics component (7, 11) is not adhesively bonded to the carrier plate (5).

5. Electronics module according to Claim 1, wherein the opening (15, 17) is not rotationally symmetrical and the electronics component (7, 11) engages into the opening (15, 17) in a positively locking manner.

6. Electronics module according to one of the preceding claims, wherein a gap (47) which is filled with material of the cured liquid-processable layer (33) is arranged between regions of the printed circuit board (3) adjoining one of the press contacts (23) and an adjacent region of the electronics component (7, 11).

7. Electronics module according to one of the preceding claims, wherein the electronics component (7, 11) is secured in a direction parallel to the carrier plate (5) by means of a fixing element (31) which engages into the carrier plate (5) and/or the printed circuit board (3).

8. Electronics module according to one of the preceding claims, wherein the carrier plate (5) and/or the printed circuit board (3) are/is formed with fibre-reinforced epoxy resin.

9. Electronics module according to one of the preceding claims, wherein the carrier plate (5) is formed with a plastic, in particular polyamide, and/or with metal.

10. Electronics module according to one of the preceding claims, wherein the carrier plate (5) has a metal-filled via (27) and/or an inlay (43) with an increased thermal conductivity in comparison to surrounding regions.

11. Controller, in particular transmission controller for a motor vehicle, having an electronics module (1) according to one of the preceding claims.

## Revendications

1. Module électronique (1), présentant :
une plaque de support (5) ;
une carte de circuits imprimés (3) dotée de pistes conductrices disposées sur celle-ci ;
au moins un composant électronique (7, 11) ;
le composant électronique (7, 11) étant relié électriquement à des pistes conductrices de la carte de circuits imprimés (3) par des contacts à pression (23) ;
**caractérisé en ce que**
au moins des zones partielles (9, 13) du composant électronique (7, 11) présentent un socle (10, 14), une distance entre la plaque de support (5) et la carte de circuits imprimés (3) correspondant à une épaisseur du socle (10, 14), et le socle (10, 14) est pris en sandwich entre la plaque de support (5) et la carte de circuits imprimés (3) de telle sorte que le composant électronique (7, 11) est immobilisé par complémentarité de forme dans une direction transversale à la plaque de support (5) ;
et des zones de pistes conductrices de la carte de circuits imprimés (5) sont recouvertes d'une couche durcie (33), pouvant être façonnée sous forme liquide, de manière adjacente à l'un des contacts à pression (23), et la carte de circuits imprimés (3) présentant une ouverture (15, 17) et le composant électronique (7, 11) faisant saillie à travers l'ouverture (15, 17).

2. Module électronique selon la revendication 1, dans lequel les contacts à pression (23) du composant électronique (7, 11) viennent en prise dans des trous traversants (25) dans la carte de circuits imprimés (3), et la couche durcie (33), pouvant être façonnée sous forme liquide, recouvre au moins des zones partielles des trous traversants (25).

3. Module électronique selon l'une quelconque des revendications précédentes, dans lequel la couche durcie (33), pouvant être façonnée sous forme liquide, est composée d'un adhésif ou d'un vernis.

4. Module électronique selon l'une quelconque des revendications précédentes, dans lequel le composant électronique (7, 11) n'est pas collé à la plaque de support (5).

5. Module électronique selon la revendication 1, dans lequel l'ouverture (15, 17) ne présente pas de symétrie de révolution, et le composant électronique (7, 11) vient en prise dans l'ouverture (15, 17) par complémentarité de forme.

6. Module électronique selon l'une quelconque des revendications précédentes, dans lequel un intervalle (47) rempli du matériau de la couche durcie (33) pouvant être façonnée sous forme liquide est disposé entre des zones de la carte de circuits imprimés (3), de manière adjacente à l'un des contacts à pression (23), et une zone voisine du composant électronique (7, 11).

7. Module électronique selon l'une quelconque des revendications précédentes, dans lequel le composant électronique (7, 11) est immobilisé dans une direction parallèle à la plaque de support (5) au moyen d'un élément de fixation (31) venant en prise dans la plaque de support (5) et/ou la carte de circuits imprimés (3).

8. Module électronique selon l'une quelconque des revendications précédentes, dans lequel la plaque de support (5) et/ou la carte de circuits imprimés (3) est/sont réalisée(s) par une résine époxy renforcée par des fibres.

9. Module électronique selon l'une quelconque des revendications précédentes, dans lequel la plaque de support (5) est réalisée en matière plastique, en particulier en polyamide, et/ou en métal.

10. Module électronique selon l'une quelconque des revendications précédentes, dans lequel la plaque de support (5) présente un trou d'interconnexion (27) rempli de métal et/ou une incrustation (43) ayant une conductibilité thermique accrue en comparaison avec les zones environnantes.

11. Appareil de commande, en particulier appareil de commande de boîte de vitesses pour un véhicule automobile, présentant un module électronique (1) selon l'une quelconque des revendications précédentes.
